# FASCICULE DE BREVET EUROPEEN

(11) **EP 3 009 677 B1**
(45) Date de publication et mention de la délivrance du brevet: **07.06.2017**
(21) Numéro de dépôt: 15189405.2
(22) Date de dépôt: 12.10.2015
(51) Int. Cl.: F04B 43/04, H01L 23/473

(54) **DISPOSITIF DE REFROIDISSEMENT PAR LIQUIDE CALOPORTEUR POUR COMPOSANTS ELECTRONIQUES**
VORRICHTUNG ZUM KÜHLEN MIT WÄRMEÜBERTRAGUNGSMEDIUM FÜR ELEKTRONISCHE BAUTEILE
DEVICE FOR COOLING BY HEAT TRANSFER LIQUID FOR ELECTRONIC COMPONENTS

(30) Priorité: 17.10.2014 FR 1460022
(43) Date de publication de la demande: 20.04.2016
(73) Titulaire: Commissariat à l'Énergie Atomique et aux Énergies Alternatives, 75015 Paris (FR)
(72) Inventeur: BAILLIN, Xavier, 38920 CROLLES (FR)
(74) Mandataire: Brevalex

(56) Documents cités:
- EP-A1- 0 134 614
- EP-A1- 2 407 416
- WO-A2-2005/060593
- DE-A1-102009 013 913
- US-A1- 2002 184 907
- US-A1- 2003 085 024
- US-A1- 2008 283 224

## Description

### DOMAINE TECHNIQUE ET ART ANTÉRIEUR

La présente invention concerne le domaine des composants électroniques et notamment des dispositifs microélectroniques et microsystèmes et plus particulièrement celui des structures de refroidissement de composants à l'aide d'un liquide caloporteur.

De par la plus en plus forte densité d'intégration des composants au sein des dispositifs micro-électroniques, ceux-ci sont davantage sujets à des problèmes d'échauffement.

Une solution pour empêcher un échauffement trop important d'un dispositif doté de composants électroniques consiste à lui accoler une enceinte dans laquelle on fait circuler un liquide caloporteur.

La circulation du liquide de refroidissement peut être réalisée à l'aide d'un moyen d'actionnement doté d'un moteur, comme par exemple dans le document US 2008/0135216 A.

Une autre solution pour contrôler la température d'un composant microélectronique prévoit une mise en oeuvre d'un réseau fluidique dans lequel on utilise une pompe pour faire circuler le liquide caloporteur.

De tels systèmes de refroidissement avec pompe ou moteur sont complexes à fabriquer.

En variante, il est possible de prévoir un actionneur électrostatique ou piézo-électrique du fluide. Le document US 2002/184907 présente un dispositif pour refroidir un composant avec un support comportant un réseau fluidique et qui est muni de membranes actionnées par un moyen piézoélectrique.

Il se pose le problème de trouver un nouveau dispositif de refroidissement par liquide caloporteur, en particulier permettant un refroidissement amélioré.

### EXPOSÉ DE L'INVENTION

Un mode de réalisation de la présente invention prévoit un dispositif comprenant :
- un support, destiné à recevoir ou comportant au moins un composant à refroidir, le support comportant un réseau fluidique dans lequel un liquide est destiné à circuler, le réseau comprenant une première cavité, une deuxième cavité, et au moins un premier canal reliant la première cavité à la deuxième cavité, une première membrane déformable et une deuxième membrane déformable, la première membrane et la deuxième membrane formant respectivement une paroi mobile de la première cavité et une paroi mobile de la deuxième cavité, le dispositif comprenant en outre :
- des moyens d'actionnement de la première membrane et de la deuxième membrane configurés pour permettre une déformation de la première et/ou de la deuxième membrane.

Le composant à refroidir peut être un composant électronique tel qu'une puce de circuit intégré et/ou un composant électromécanique tel qu'un microsystème électromécanique.

En déformant la première membrane, on module le volume de la première cavité, tandis qu'en déformant la deuxième membrane on fait varier le volume de la deuxième cavité. Une variation de volume de la première cavité et/ou de la deuxième cavité permet de mettre en oeuvre un déplacement de liquide dans le canal.

Un tel dispositif est plus aisé à mettre en oeuvre qu'un dispositif muni d'une pompe ou d'un moteur.

Un tel dispositif permet une circulation facilitée de liquide caloporteur et ainsi un refroidissement amélioré.

Les moyens d'actionnement des membranes peuvent être de type piézo-électrique et/ou électrostatique.

Les moyens d'actionnement, comprennent :
- au moins une première électrode disposée sur ou intégrée à la première membrane,
- au moins une deuxième électrode disposée sur ou intégrée à la deuxième membrane.

Les moyens d'actionnement comprennent également au moins une électrode fixe intégrée au support et disposée en regard de la première électrode et/ou de la deuxième électrode.

L'électrode fixe peut jouer le rôle de contre électrode commune à la première électrode et la deuxième électrode. En variante, la première électrode est associée et en regard de l'électrode fixe, tandis qu'une autre électrode fixe est associée et en regard de la deuxième électrode.

Une telle électrode fixe peut être prévue notamment lorsqu'on met en oeuvre un déplacement de la première électrode et de la deuxième électrode par établissement d'une force d'attraction électrostatique.

L'électrode fixe peut être disposée sur une protubérance placée en regard de la première électrode ou de la deuxième électrode ou de chacune de ces électrodes.

Cela peut permettre d'appliquer des niveaux réduits de potentiels appliqués aux électrodes.

L'électrode fixe peut être également disposée sur plusieurs protubérances en regard de la première électrode ou de la deuxième électrode ou de chacune de ces électrodes.

Cela peut permettre de mettre en oeuvre une déformation améliorée et plus efficace des membranes.

Selon un mode avantageux, au moins une rainure est agencée entre deux desdites protubérances, la rainure s'étendant dans une direction parallèle à celle du premier canal.

Ainsi, les rainures entre protubérances peuvent être agencées de manière à faciliter la circulation de fluide dans le canal de la première cavité vers la deuxième cavité ou de la deuxième cavité vers la première cavité.

Dans le cas d'un actionnement piézoélectrique, au moins l'une des première et deuxième membranes peut comprendre une couche de matériau piézoélectrique.

Les moyens d'actionnement peuvent être prévus de sorte que la première et la deuxième membrane peuvent être actionnées indépendamment l'une par rapport à l'autre. Par indépendamment on entend que les membranes peuvent être déformées simultanément ou successivement, mais être soumises à des déformations différentes l'une par rapport à l'autre.

Selon un mode de réalisation particulier des moyens d'actionnement, ceux-ci peuvent être configurés pour alternativement:
- déplacer la première membrane de manière à réduire le volume de la première cavité, puis
- déplacer la deuxième membrane de la deuxième cavité de sorte à diminuer le volume de la deuxième cavité.

On peut ainsi mettre en oeuvre un mouvement de va-et-vient du liquide dans le canal et améliorer la dissipation thermique.

Les moyens d'actionnement peuvent être configurés pour alternativement :
- exercer une contrainte sur la première membrane tandis que la deuxième membrane n'est pas soumise à une contrainte par les moyens d'actionnement,
- exercer une contrainte sur la deuxième membrane tandis que la première membrane n'est pas soumise à une contrainte par les moyens d'actionnement.

On a donc dans ce cas de figure, lors d'une première phase, un actionnement de la première membrane par les moyens d'actionnement susceptible d'entrainer un déplacement de liquide dans le canal, ce déplacement provoquant un déplacement de la deuxième membrane qui n'est alors pas soumise à une contrainte par les moyens d'actionnement, puis lors d'une deuxième phase, un actionnement de la deuxième membrane susceptible d'entrainer un déplacement de liquide en sens inverse dans le canal, ce déplacement de liquide provoquant un déplacement de la première membrane qui n'est alors pas soumise à une contrainte par les moyens d'actionnement.

Dans ce cas, on a, pendant la première phase : un actionnement actif sur la première membrane et un actionnement passif de la deuxième membrane, et pendant la deuxième phase : un actionnement actif sur la deuxième membrane et un actionnement passif de la première membrane.

En variante, les moyens d'actionnement peuvent être configurés pour :
- conjointement au déplacement de la première membrane de manière à réduire le volume de la première cavité, déplacer la deuxième membrane de sorte à augmenter le volume de la deuxième cavité, puis
- conjointement au déplacement de la deuxième membrane de manière à réduire le volume de la deuxième cavité, déplacer la première membrane de la première cavité de sorte à augmenter le volume de la première cavité.

Dans ce cas, on a pendant la première phase un actionnement actif sur la première et la deuxième membrane, et pendant la deuxième phase un actionnement actif sur la première et deuxième membranes.

Les moyens d'actionnement peuvent comprendre des moyens de polarisation ou un circuit de polarisation de la première électrode et de la deuxième électrode. Avantageusement, ces moyens de polarisation sont intégrés au support.

Selon une possibilité de mise en oeuvre, les moyen d'actionnement peuvent comprendre des moyens de polarisation ou un circuit de polarisation configuré(s) pour à appliquer un premier potentiel à la première électrode et un deuxième à la deuxième électrode, différent du premier potentiel. Ainsi, la première électrode et la deuxième électrode peuvent être polarisées indépendamment l'une de l'autre.

Selon un mode de réalisation particulier, le dispositif peut comprendre en outre un élément conducteur thermique à proximité du canal ou en contact avec le canal, l'élément conducteur thermique traversant le support et ayant une conductivité thermique plus élevée que la conductivité thermique du support.

On améliore ainsi la dissipation thermique.

L'élément conducteur thermique peut être relié à une zone conductrice située sur une face du support opposée à une autre face sur laquelle le composant est destiné à être disposé.

On réalise ainsi une meilleure répartition de la dissipation thermique.

Selon une possibilité de mise en oeuvre du dispositif, celui-ci peut être doté d'un élément de connexion électrique traversant le support, cet élément de connexion reliant une première face du support sur laquelle le composant est destiné à être disposé et une deuxième face opposée à la première face.

Selon une possibilité de mise en oeuvre du réseau fluidique, celui-ci peut être doté d'un ou plusieurs canaux fluidiques supplémentaires et d'une ou plusieurs cavités supplémentaires avec des membranes déformables en regard des cavités supplémentaires.

Selon une possibilité de mise en oeuvre, le dispositif peut être doté d'un moyen ou d'un circuit de mesure de la température du composant et d'un moyen de commande ou d'un circuit de commande des moyens d'actionnement en fonction de la température mesurée par le moyen de mesure.

Un mode de réalisation de la présente invention prévoit un procédé de fabrication d'un dispositif tel que défini plus haut.

Un mode de réalisation de la présente invention prévoit un procédé de de réalisation d'un dispositif pour refroidir un composant comprenant une étape consistant à assembler un premier substrat avec un deuxième substrat dans lequel un canal fluidique est au moins partiellement réalisé.

Après assemblage, on peut former des membranes sur le deuxième substrat.

Ces membranes peuvent être réalisées à partir d'un ou plusieurs zones amincies du deuxième substrat.

En variante ou en combinaison, ces membranes peuvent être formées par report d'au moins une couche sur le deuxième substrat.

Dans ce cas, les membranes peuvent fermer des ouvertures pratiquées dans le deuxième substrat.

Un mode de réalisation de l'invention prévoit ainsi un procédé de réalisation d'un dispositif tel que défini plus haut comprenant des étapes consistant à :
- assembler un premier substrat avec un deuxième substrat ledit au moins canal fluidique et des ouvertures destinées à former la première et ou la deuxième cavité étant au moins partiellement réalisés dans le premier et/ou le deuxième substrat,
- former les membranes à partir d'une ou plusieurs zones amincies du deuxième substrat et/ou par report d'au moins une couche sur le deuxième substrat de manière à fermer les ouvertures.

Avant la fermeture des ouvertures par les membranes, le procédé peut comprendre une étape de remplissage dudit au moins un canal et des cavités par un liquide

En variante, le procédé peut comprendre après la fermeture des ouvertures par les membranes une étape de remplissage dudit au moins canal et des cavités, cette étape consistant à :
- pratiquer au moins un évent dans le deuxième substrat ou le premier substrat de sorte que ledit évent débouche dans ledit au moins canal,
- remplir ledit au moins canal et les cavités par un liquide dispensé à travers ledit évent,
- déposer un film de fermeture dudit au moins évent.

Selon un mode de réalisation particulier, ledit au moins évent traverse des zones amincies du deuxième substrat.

Selon une possibilité de mise en oeuvre du procédé, le premier substrat peut être doté d'une portion conductrice traversant son épaisseur tandis que le deuxième substrat comporte une autre portion conductrice en contact avec une région sur laquelle le composant est destiné à être disposé. L'assemblage entre le premier substrat et le deuxième substrat peut dans ce cas être réalisé de sorte à mettre en contact entre elles la portion conductrice sur l'autre portion conductrice.

On forme ainsi un élément de connexion électrique traversant le support et reliant une première face du support sur laquelle le composant est disposé et une deuxième face opposée à la première face.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- La figure 1A sert à illustrer un premier exemple de dispositif comportant un réseau fluidique disposé à proximité d'un composant à refroidir et dans lequel on fait circuler un liquide par actionnement de membranes déformables ;
- Les figures 1B-1C illustrent un exemple particulier d'actionnement des membranes de manière à donner au liquide de refroidissement un mouvement de va et vient dans le réseau fluidique ;
- La figure 2 illustre une variante d'agencement dans lequel un élément conducteur thermique est disposé en contact du réseau fluidique pour améliorer la dissipation de chaleur;
- La figure 3A illustre une variante d'agencement de réseau fluidique muni d'un canal fluidique supplémentaire en regard du composant ;
- La figure 3B illustre une variante d'agencement de réseau fluidique muni de deux canaux convergents et reliés à un troisième canal;
- Les figures 4 et 5 illustrent différents agencements de réseaux fluidique avec plusieurs canaux se croisant en regard du composant à refroidir;
- La figure 6 illustre un exemple de mise en oeuvre de moyens d'actionnement électrostatiques des membranes mobiles ;
- La figure 7 illustre un exemple particulier de configuration de moyens d'actionnement électrostatiques comprenant des électrodes disposées sous les membranes déformables;
- La figure 8 illustre une variante de réalisation avec une zone conductrice supplémentaire pour améliorer la répartition de la dissipation de chaleur;
- Les figures 9A-9B illustrent un exemple de réalisation dans lequel un élément de connexion est agencé de manière à permettre une prise de contact sur le composant à refroidir ;
- Les figures 10, 11A, 11B illustrent différents exemples de configurations d'électrode d'actionnement en forme de protubérance(s) pour améliorer la déformation des membranes;
- La figure 12 illustre un exemple de mise en oeuvre de moyens d'actionnement piézoélectriques des membranes déformables ;
- Les figures 13A-13F illustrent un premier exemple de procédé de réalisation d'un dispositif à réseau fluidique doté de membranes déformables par actionnement électrostatique ;
- Les figures 14A-14C illustrent un deuxième exemple de procédé de réalisation d'un dispositif à réseau fluidique et actionnement piézoélectrique ;
- Les figures 15A-15B illustrent un premier exemple de procédé de remplissage du réseau fluidique ;
- Les figures 16A-16C illustrent un deuxième exemple de procédé de remplissage du réseau fluidique ;
- Les figures 17A-17C illustrent un troisième exemple de procédé de remplissage du réseau fluidique ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « sous », « sur », « au-dessus », « supérieure », « inférieure » etc. d'une structure s'appliquent en considérant que la structure est orientée de la façon illustrée sur les figures.

### EXPOSÉ DÉTAILLÉ DE MODES DE RÉALISATION PARTICULIERS

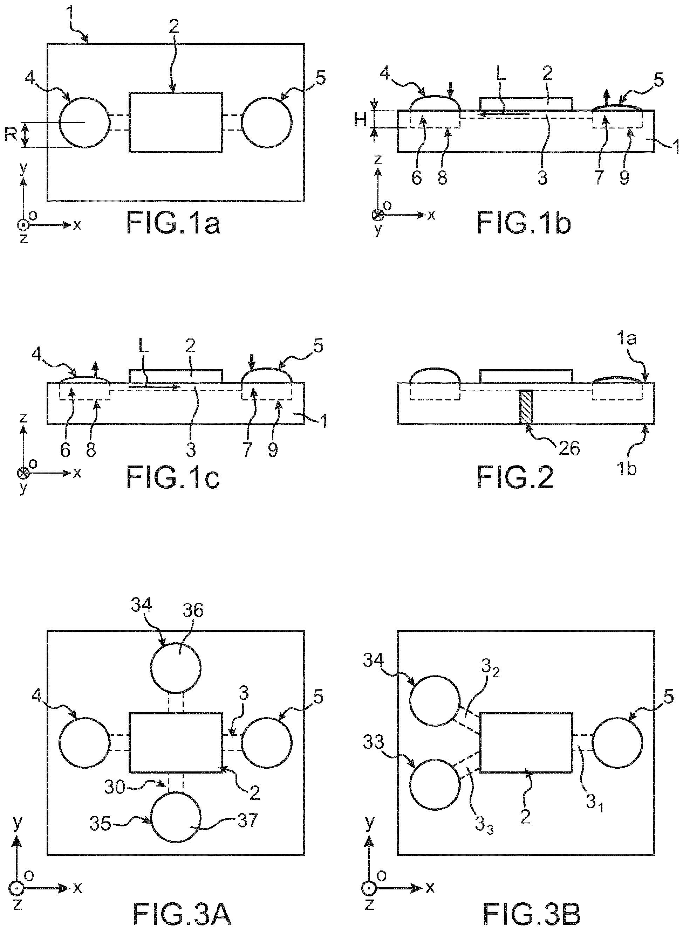

Un exemple de dispositif doté d'un réseau fluidique adapté pour refroidir un composant électronique ou électromécanique est illustré sur la figures 1A-1B (la figure 1A donnant une vue de dessus tandis que les figures 1B-1C donnent une vue en coupe transversale respectivement d'une première et d'une deuxième position du dispositif).

Le réseau fluidique est prévu dans un support 1 sur lequel un composant 2 est disposé. Le support 1 peut être sous forme d'un substrat, par exemple à base de silicium. Le réseau fluidique est disposé à proximité du composant 2 et comprend un canal 3 traversé par un liquide adapté pour permettre de refroidir le composant. Le canal 3 relie une première cavité 6 et une deuxième cavité 7 entre lesquelles le liquide est susceptible de se déplacer. Dans l'exemple particulier des figures 1A-1B, une paroi du canal 3 est placée sous et en contact avec le composant 2 afin d'assurer un meilleur refroidissement. Le canal 3 s'étend dans une direction, appelée « direction principale » entre la première cavité 6 et la deuxième cavité 7. La direction principale du canal est une direction prise parallèlement à l'axe x d'un repère orthogonal [O ; x ; y ; z] représenté sur certaines figures.

Le liquide de refroidissement est choisi de manière à avoir une bonne conductivité thermique et de sa faible viscosité. Il peut être par exemple de l'eau ou une huile ou du glycol ou bien encore un métal sous forme liquide. Un mélange de liquides peut être également prévu. Le liquide peut également comporter des particules conductrices, par exemple de type nanoparticules métalliques, de façon à améliorer les échanges thermiques entre le composant et le support.

Une circulation de liquide dans le canal 3 est réalisée par déplacement d'une ou plusieurs membranes 4, 5 déformables rattachées au support 1 et formant respectivement une paroi mobile de la première cavité 6 et une paroi mobile de la deuxième cavité 7. Les cavités 6, 7 sont également dotées de parois fixes 8, 9 formées dans le support 1.

La déformation des membranes 4, 5 et leurs déplacement entre plusieurs positions permet ainsi alternativement de réduire ou d'augmenter le volume des cavités 6, 7 afin alternativement de favoriser l'expulsion ou l'accueil de liquide dans les cavités 6, 7. Une modulation du volume des cavités 6, 7 permet ainsi de générer des déplacements de liquide. L'actionnement des membranes 4, 5 peut être prévu de sorte que la déformation appliquée à une membrane est différente de celle appliquée à l'autre membrane.

Dans l'exemple particulier de réalisation de la figure 1, les membranes 4, 5 ont une forme de disque, avec un rayon R compris par exemple entre 1 et 10 mm. Les cavités 6, 7 ont une hauteur ou profondeur H comprise par exemple entre 50 et 500 µm.

Un exemple d'actionnement particulier des membranes 4, 5, dans lequel on fait varier alternativement le volume des cavités 6, 7, est illustré sur les figures 1B-1C.

La figure 1B illustre une première position du dispositif dans laquelle la première cavité 6 a un volume donné qui peut être maximal et correspond à une première position de la première membrane 4, tandis que la deuxième cavité 7 a un autre volume qui peut être minimal et correspond à une première position de la deuxième membrane 5.

Une deuxième position du dispositif est illustrée sur la figure 1C, la première cavité 6 ayant alors un volume minimal correspondant à une deuxième position de la première membrane 4, tandis que la deuxième cavité 7 a un volume maximal correspondant à une deuxième position de la deuxième membrane 5.

Des moyens d'actionnement des membranes 4, 5 peuvent être ainsi configurés pour permettre de faire passer le dispositif de la première à la deuxième position et inversement selon une séquence préétablie. On peut ainsi générer un mouvement de va et vient du liquide dans le canal 3 afin d'améliorer le refroidissement du composant 2 qui se trouve au-dessus.

Une variante de réalisation du dispositif précédemment décrit prévoit en outre un élément 26 conducteur thermique traversant le support 1 et disposé à proximité du canal 3 fluidique ou en contact avec ce dernier. Par « à proximité » on entend ici que l'élément 26 est situé à une distance de moins de 100 µm du canal. Cela permet de favoriser une évacuation thermique vers l'extérieur, lorsque le liquide qui se trouve dans le canal 3 s'échauffe consécutivement à un échauffement du composant 2. Dans l'exemple de réalisation illustré sur la figure 2, l'élément conducteur thermique 26 s'étend du canal 3 jusque vers une face 1b du support 1, appelée « face arrière » c'est-à-dire une face opposée à celle appelée « face avant », notée 1a, sur laquelle le composant 2 est disposé. L'élément 26 conducteur thermique peut être prévu à base d'un matériau dont la conductivité thermique est supérieure à celle du matériau du support 1. L'élément conducteur thermique 26 peut être métallique, par exemple à base de Cu, et peut être réalisé selon une technologie semblable à celle d'un élément de connexion électrique de type TSV (TSV pour « Through Silicon Via »). L'élément conducteur thermique 26 peut être enrobé d'une couche barrière de diffusion de métal, par exemple en nitrure de titane. Cette couche barrière de diffusion peut être elle-même enrobée d'une couche de matériau diélectrique tel que par exemple du SiO₂, en particulier lorsque le support 1 est à base d'un semiconducteur ou conducteur.

L'élément conducteur thermique 26 peut être également enrobé et en contact d'une couche d'isolant thermique. Cela permet de favoriser la diffusion de la chaleur par le bais de l'élément conducteur thermique 26 sans perte latérale. Un exemple d'isolant thermique qui peut être utilisé est le SiO₂.

Le dispositif n'est pas limité à un seul élément conducteur thermique traversant le support 1 et peut comprendre un ou plusieurs éléments conducteurs thermiques supplémentaires, dont les dimensions et la répartition sont adaptées en fonction d'une estimation de la localisation de points d'échauffement du composant 2.

Le dispositif n'est pas limité à un réseau fluidique muni d'un seul canal et de deux cavités. On peut en effet prévoir un dispositif muni de n canaux fluidiques (avec n ≥ 1) et de m cavités (avec m ≥ 2) pour former le réseau fluidique.

Dans ce cas, un agencement matriciel de membranes ou de parois flexibles peut être réalisé, certaines membranes pouvant suivre entre elles des séquences de mouvements ou de déformations différentes.

Un autre exemple de réalisation, illustré sur la figure 3A, prévoit un réseau fluidique muni d'une pluralité de canaux fluidiques 3, 30 sous le composant 2, et en particulier d'un deuxième canal 30 comportant à ses extrémités deux cavités supplémentaires 36, 37 entre lesquelles un liquide est destiné à circuler. Un déplacement de membranes 34, 35 formants des parois mobiles de ces cavités supplémentaires situées aux extrémités du deuxième canal 30 permet de mettre en mouvement un liquide dans ce deuxième canal 30. Les canaux 3, 30 peuvent être agencées de manière à communiquer entre eux. Le réseau fluidique n'est pas nécessairement limité à deux canaux. Sur l'agencement de réseau fluidique de la figure 3A, le canal 3 suit une première direction (la direction de l'axe x sur la figure 3A) tandis que l'autre canal 30 suit une deuxième direction (la direction de l'axe y du repère orthogonal [O ; x ; y ; z] sur la figure 3A) différente de la première direction et qui peut être orthogonale à la première direction.

Sur la figure 3B est illustré un autre agencement de réseau fluidique, avec deux premiers canaux convergents 3₂, 3₃ reliés par une extrémité à un troisième canal 3₁. Les deux premiers canaux 3₂, 3₃ sont dotés chacun d'une autre extrémité, cette autre extrémité débouchant sur une cavité. Les cavités auxquelles les canaux 3₂, 3₃ sont reliés ont avantageusement des dimensions semblables entre elles et sont surmontées respectivement de membranes 34, 35. Le troisième canal 3₁ débouche quant à lui sur une cavité surmontée par une autre membrane 5 et a un volume égal ou supérieur à la somme des volumes des cavités situées aux extrémités des canaux 3₂, 3₃. La section du troisième canal 3₁ est avantageusement égale à la somme des sections des deux premiers canaux 3₂, 3₃. Dans ce cas on prévoit avantageusement les deux premiers canaux 3₂, 3₃ de même section. Les membranes déformables 34, 35 peuvent être actionnées en même temps et subir un même déplacement ou une même déformation de façon à provoquer un va et vient de liquide entre la cavité de volume plus important et les autres cavités de volume plus faible.

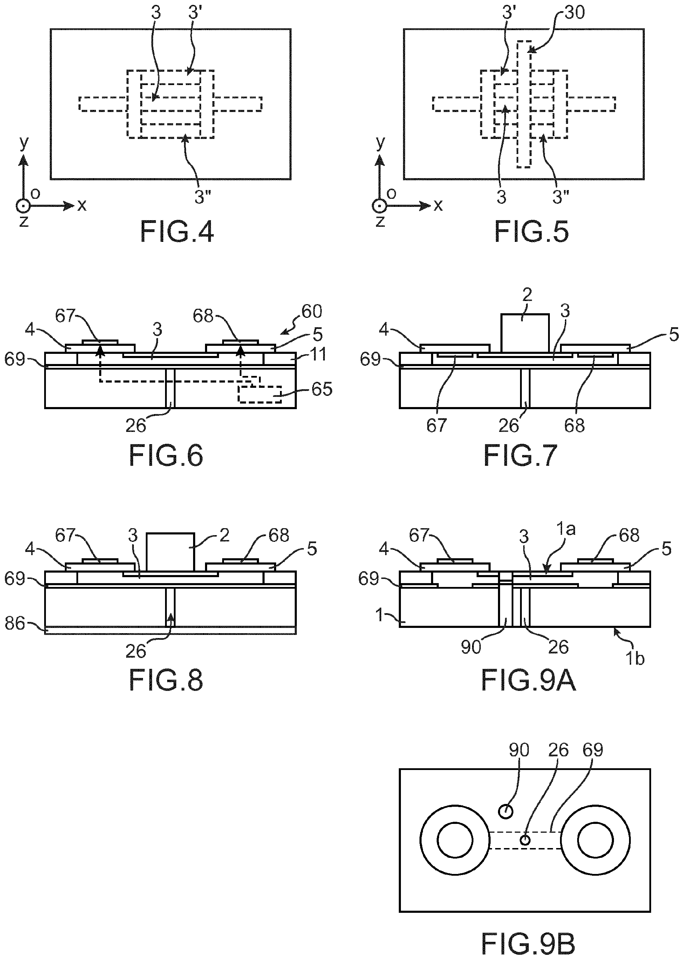

Sur la figure 4, un autre exemple de configuration du réseau fluidique de refroidissement est donné, avec des canaux ou tronçons de canaux se croisant et communicant entre eux. Le canal 3 forme une portion principale communicant avec d'autres portions secondaires 3', 3" qui peuvent être parallèles et reliées à cette portion principale par le biais de tronçons orthogonaux à la portion principale.

La variante de réalisation de la figure 5 prévoit en outre un canal 30 orthogonal au canal principal 3.

Afin de limiter des pertes de charge dans le réseau fluidique, les canaux 3, 3', 3" peuvent être dotés d'une section transversale de formes arrondie, voire ovoïde ou circulaire. Par section transversale, on entend ici une section prise parallèlement à l'axe z du repère orthogonal sur les figures 4 et 5 ou orthogonal au plan principal du support (le plan principal du support étant un plan passant par le support et parallèle au plan [O ; x ; y] sur la figure 3). On peut également limiter les pertes de charge aux intersections des canaux, en prévoyant des angles aux intersections entre les canaux qui sont inférieurs à 90°.

Dans l'un ou l'autre des exemples de réalisation qui viennent d'être décrits, le passage d'une position à l'autre des membranes 4, 5 formant des parois mobiles de cavités 6, 7 pour permettre l'expansion ou la rétractation du volume de ces cavités 6, 7 et le déplacement de liquide dans le ou les canaux du réseau fluidique, est être réalisé par le biais de moyens d'actionnement.

Un exemple de réalisation de moyens d'actionnement 60 de type électrostatique est donné sur la figure 6. Une mise en mouvement du liquide dans un canal 3 reliant des cavités 6, 7 est ici réalisée en faisant varier des forces d'attraction électrostatiques s'exerçant sur les membranes 4, 5.

Les membranes 4, 5 sont pour cela munies respectivement d'électrodes 67, 68 distinctes placées en regard d'une électrode 69 fixe intégrée au support 1.

Une commande indépendante entre elles des électrodes mobiles 67, 68 peut être prévue afin de permettre de moduler le volume de la cavité 6, par exemple en l'augmentant, tout en modulant de manière différente le volume de la cavité 7 par exemple en le diminuant. Dans cet exemple de réalisation, les électrodes 67, 68 ne sont pas connectées entre elles et peuvent être ainsi polarisées indépendamment l'une de l'autre. On peut ainsi déformer une membrane tout en déformant l'autre d'une manière différente, en fonction des potentiels respectifs qui leurs sont appliqués.

Les électrodes 67, 68 solidaires des membranes 4, 5 sont mobiles et se rapprochent ou s'écartent de l'électrode fixe 69 en fonction du potentiel qui leur est appliqué. Dans cet exemple de réalisation, on fait varier la forme d'une membrane 4, 5 par modulation de l'attraction entre une électrode 67, 68 mobile de la membrane et une électrode fixe 69 du support. Les potentiels appliqués sur les électrodes peuvent être par exemple de l'ordre d'une dizaine de volts.

Les moyens d'actionnement peuvent comprendre des moyens de commande 65 configurés pour commander la polarisation des électrodes et qui est adapté pour placer les électrodes 67, 68 dans un état de polarisation dans lequel au moins une première électrode 67 est mise à un premier potentiel V1, et au moins une autre électrode 68 est mise à un deuxième potentiel V2, avec V2≠V1. Ainsi, les électrodes 67, 68 sont susceptibles d'être commandées indépendamment l'une des autres par les moyens de commande 65 de polarisation. Le moyens de commande 65 de la polarisation des électrodes peuvent être sous forme d'un circuit comprenant un circuit d'adressage des électrodes 67, 68. Sur la figure 6, les moyens de commande 65 sont intégrés au support 1.

Dans l'exemple de réalisation particulier de la figure 6, l'électrode fixe 69, est avantageusement reliée à l'élément conducteur thermique 26 qui sert alors également d'élément conducteur de l'électricité et permet de réaliser une reprise de contact. L'électrode fixe 69 peut être commune et formée en regard d'un ensemble de plusieurs électrodes 67, 68.

Dans l'exemple particulier donné sur la figure 6 où l'électrode 69 sert d'électrode fixe commune, elle peut également avoir servi à favoriser l'assemblage entre une partie supérieure du dispositif comportant les électrodes mobiles 67, 68 et une partie inférieure comportant l'électrode fixe 69. Tel est le cas, par exemple, lorsque l'électrode 69 est à base d'un métal tel que du Cu ou de l'Au et que l'on effectue l'assemblage par un collage métal/métal, par exemple de Cuivre sur du Cuivre ou d'or sur de l'or. La distance entre électrode mobile 67 ou 68 et électrode fixe 69 peut être telle qu'une variation de volume des cavités 4, 5 comprise entre 5 et 50% peut être mise en oeuvre.

L'actionnement des membranes 4, 5 à l'aide des moyens de commande 65 peut être asservi à, ou déclenché grâce à des mesures de température effectuées localement dans le composant 2. Ainsi, les moyens de commande peuvent être adaptés pour détecter un signal témoignant d'une élévation de température du composant 2. Des moyens de mesure de température, par exemple sous forme d'un thermomètre intégré réalisé à partir d'au moins un transistor et/ou d'un thermocouple peuvent être intégrés et permettre de mesurer la température localement et de piloter un autre circuit logique contrôlant les moyens de commande.

Dans l'exemple de la figure 6, les électrodes 67, 68 sont placées sur les membranes 4, 5.

Il est également possible de positionner les électrodes 67, 68 sous les membranes 4, 5, par exemple de sorte qu'elles se situent dans les cavités 6, 7 (figure 7). Dans ce cas, on rapproche les électrodes mobiles 67, 68 par rapport à l'électrode fixe 69 ce qui rend l'actionnement plus aisé ou avec des niveaux de tensions plus faibles.

L'électrode fixe 69 peut être en contact avec l'élément conducteur thermique 26, ce qui peut permettre placer l'électrode fixe 69 à un potentiel donné appliqué à l'élément conducteur thermique 26, lorsque celui-ci est également conducteur électrique.

Une variante de réalisation illustrée sur la figure 8 prévoit d'intégrer une zone conductrice 86 sur la face arrière 1b du support 1. Cette zone conductrice 86 est reliée à un élément conducteur thermique 26 traversant le support 1, et permet de répartir la chaleur sur la face arrière 1b du support 1. Cette zone conductrice 86 peut être en métal tel que par exemple du cuivre et avoir une épaisseur qui peut être comprise entre plusieurs micromètres et plusieurs dizaines de micromètres. La zone conductrice 86 peut être destinée à accueillir une structure de radiateur ou de dissipateur thermique, afin de dissiper de la chaleur véhiculée par l'élément conducteur thermique 26 et la zone conductrice 86. La structure de radiateur ou de dissipateur peut être fixée par exemple par collage direct ou être formée par impression 3D et ainsi comporter des motifs d'une épaisseur comprise entre plusieurs centaines de µm et plusieurs mm.

Une autre variante de réalisation illustrée sur les figures 9A-9B, prévoit un élément de connexion 90 configuré pour réaliser une prise de contact électrique sur le composant 2 que l'on souhaite refroidir. Cet élément de connexion 90 peut être sous forme d'un via traversant le support 1 et qui s'étend entre la face avant 1a et la face arrière 1b du support 1. On peut ainsi connecter électriquement le composant 2 à refroidir par la face arrière du support 1. L'élément de connexion 90 peut être agencé de manière à traverser le support 1 sans être en contact avec l'électrode fixe 69.

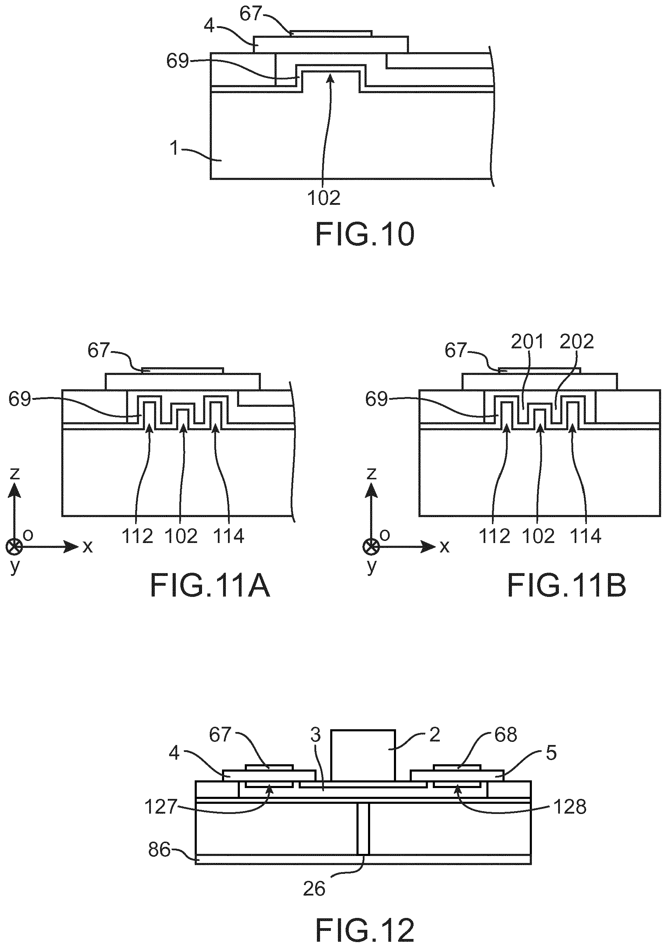

Différentes variantes d'agencement de l'électrode fixe 69 en regard d'une membrane 4 sont données sur les figures 10 et 11A.

Le support 1 peut comporter un motif en relief 102 encore appelé « protubérance », et qui est disposé dans une cavité 6 et sur lequel l'électrode fixe 69 est agencée. Cela permet de rapprocher l'électrode mobile 67 et de pouvoir mieux déformer la membrane 4 sur laquelle est disposée l'électrode 68 mobile (figure 10).

Plusieurs autres protubérances 112, 114 de hauteurs différentes peuvent être prévues, afin de pouvoir faciliter la déformation de la membrane et lui faire adopter un profil différent. La figure 11A donne un exemple particulier de réalisation dans lequel des protubérances 112, 114 périphériques de hauteur H₂ sont formées autour d'une protubérance 102 centrale de hauteur H₁, avec H₁<H₂.

Les protubérances périphériques 112, 114 peuvent avoir entre elles des géométries différentes dans un plan parallèle au plan principal du support 1.

L'ajout de protubérances périphériques 102, 112, 114 permet également de prévoir des tensions de polarisation plus basses pour déformer la membrane 4.

Un autre exemple d'agencement est donné sur figure 11B avec des rainures 201, 202 entre les protubérances, les rainures 201, 202 encore appelées « cannelures » sont orientées parallèlement à la direction principale du canal 3 reliant les cavités 6 et 7 (i.e. parallèlement au vecteur x du repère orthogonal [O ; x ; y ; z]). Le fluide circulant entre les cavités 6 et 7 est amené à traverser les rainures ou cannelures 201, 202.

Un tel agencement des protubérances 112, 102, 114 permet alors d'assurer une meilleure circulation de fluide dans le canal tout en assurant un bon contrôle de la forme de membrane.

Un autre exemple de réalisation du dispositif avec des moyens d'actionnement de type piézoélectrique est donné sur la figure 12. Pour permettre de réaliser une déformation des membranes 4, 5 celle-ci sont munies de paires d'électrodes respectivement 67, 127 et 68, 128 disposées de part et d'autre d'une couche 125 ou d'un empilement comportant au moins une sous couche à base de matériau piézoélectrique tel que par exemple du PZT (Titano-Zirconate de Plomb). Pour déformer la première membrane 4, on applique un premier couple de potentiels aux électrodes 67, 127, tandis qu'on applique un deuxième couple de potentiels aux électrodes 68, 128, afin de déformer la deuxième membrane 5.

Un dispositif à réseau fluidique tel que décrit précédemment est adapté au refroidissement de dispositifs microélectroniques ou de puces ou de microsystèmes susceptibles de dégager de la chaleur et qu'il convient d'évacuer en vue d'assurer leur bon fonctionnement et leur durée de vie. On peut refroidir en particulier des puces de circuits intégrés réalisées en technologie 3D, c'est-à-dire avec des éléments, tel que des transistors, répartis sur plusieurs niveaux de couches semi-conductrices superposées.

Un dispositif à réseau fluidique tel que décrit précédemment peut présenter un faible encombrement suivant z, ce qui peut lui permettre d'être intégré dans des appareils nécessitant un faible encombrement en z tel par exemple les téléphones portable ou les tablettes.

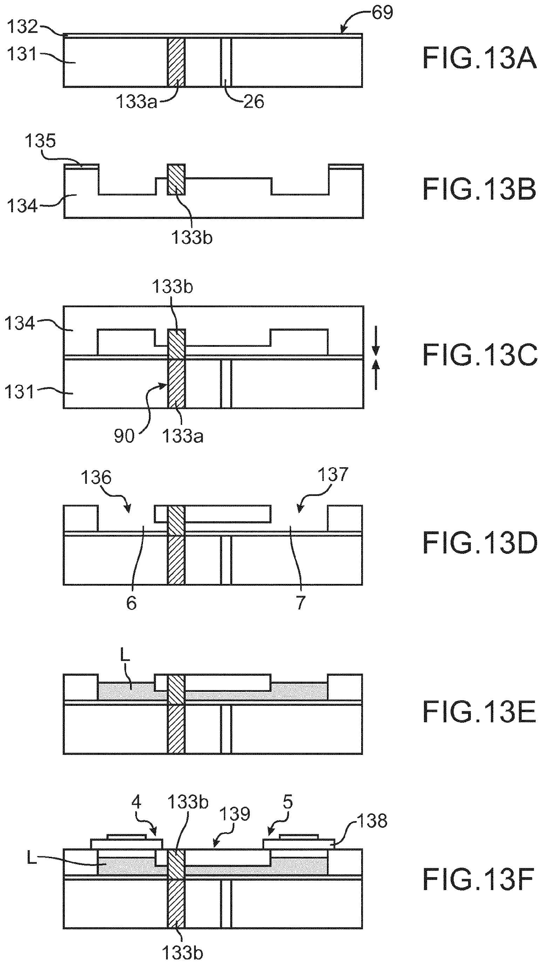

Un exemple de procédé de réalisation d'un dispositif à réseau fluidique tel que décrit précédemment va à présent être donné en liaison avec les figures 13A-13F.

La figure 13A illustre une étape de réalisation de l'électrode fixe 69 par dépôt d'une couche métallique 132 sur une face avant d'un premier substrat 131 qui formera une partie inférieure du support 1. Le premier substrat 131 peut être semiconducteur et par exemple à base de Si. La couche métallique 132 peut être en cuivre et avoir une épaisseur par exemple de l'ordre du micron. Lorsque l'on souhaite réaliser une électrode fixe 69 recouvrant un ou plusieurs motifs en relief ou protubérances comme dans l'exemple des figures 10, 11, on structure le substrat 131 préalablement au dépôt métallique, par exemple par gravure.

Un élément 26 conducteur thermique venant en contact avec la couche métallique 132, peut être réalisé par formation d'un trou traversant le premier substrat 131. Le trou peut être réalisé par exemple par photolithographie puis gravure par exemple de type DRIE (DRIE pour « Deep Reactive Ion Etching » ou « gravure ionique réactive profonde ») avec arrêt sur la couche métallique 132. L'élément conducteur 26 peut avoir une largeur comprise entre 10 microns et plusieurs centaines de microns. Lorsque cette largeur est plus faible, on peut éventuellement amincir le substrat 131 par sa face arrière au préalable. Puis, on tapisse le trou par une couche d'isolation électrique par exemple à base de SiO₂, et d'épaisseur par exemple de l'ordre de plusieurs centaines de nanomètres.

Lorsque l'épaisseur de cette couche est de l'ordre du micromètre, cette couche peut avoir une fonction d'isolant thermique.

Ensuite, on peut éventuellement déposer dans le trou une couche barrière à la diffusion de métal. Cette couche barrière peut être par exemple à base TiN, et avoir une épaisseur par exemple de plusieurs dizaines de nanomètres. On effectue ensuite une gravure, en fond de trou, de ces couches d'isolation et barrière avant de remplir le trou d'un matériau métallique.

Le matériau métallique de remplissage est par exemple du cuivre. Le remplissage peut être réalisé par dépôt physique en phase vapeur (ou PVD pour l'anglais « Physical Vapor Deposition ») ou par exemple par dépôt chimique en phase vapeur (ou CVD pour l'anglais « Chemical Vapor Deposition ») puis, par dépôt électrochimique.

En variante, on peut réaliser l'élément conducteur thermique 26, avant de former l'électrode fixe 69.

Une portion conductrice inférieure 133a de l'élément de connexion 90 tel qu'illustré sur les figures 9A-9B peut être également réalisée lors de la formation de l'élément conducteur thermique 26. Cette portion 133a peut être ainsi réalisée en même temps que l'élément 26 par formation d'un trou dans le substrat 131 puis remplissage du trou par du matériau métallique.

Pour réaliser une partie supérieure du support 1 sur laquelle les membranes 4, 5 et électrodes mobiles 67, 68 seront fixées, on peut prévoir un deuxième substrat 134 sur lequel on forme des zones métalliques 135 (figure 13B). Les zones métalliques 135 peuvent être par exemple à base cuivre et d'épaisseur par exemple de l'ordre de 1 micron. Ces zones métalliques 135 sont prévues pour permettre l'assemblage entre les deux substrats 131 et 134. Dans le cas où le procédé d'assemblage prévu est un collage direct, en particulier de type Cuivre sur Cuivre, une préparation de la surface des zones 135 et de la surface de la couche 132 peut être réalisée à l'aide d'un polissage mécano-chimique (CMP).

Une portion conductrice supérieure 133b d'un élément de connexion 90 (tel que celui illustré sur les figures 9A-9B) peut être également réalisée dans le deuxième substrat 134. Cette portion conductrice supérieure 133b est formée en contact avec une région du deuxième substrat sur laquelle un composant à refroidir est destiné à être disposé.

Dans le deuxième substrat 134, on forme ensuite un réseau fluidique comportant au moins un canal et des cavités aux extrémités du canal.

Ensuite, on réalise un assemblage du premier substrat 131 et du deuxième substrat 134 (figure 13C).

L'assemblage peut être effectué selon un procédé de collage direct, avantageusement métal/métal (Cu/Cu ou Au/Au) ou par brasure fusible utilisant un alliage eutectique par exemple à base d'AuSn (ayant une température de fusion de l'ordre de 280°C), ou par exemple à base d'AuSi (avec une température de fusion de l'ordre de 363°C), AlGe (avec température de fusion de l'ordre de 419°C). En variante, un collage direct oxyde/oxyde (SiO₂/SiO₂) peut être réalisé.

L'assemblage entre les deux substrats 131, 134 est prévu de manière à former un support doté d'un réseau fluidique étanche. Durant cette étape, on peut également réaliser un assemblage par collage direct entre la portion conductrice inférieure 133a réalisée dans le premier substrat 131 et la portion conductrice supérieure 133b réalisée dans le deuxième substrat 134 pour former l'élément de connexion 90.

Puis, on effectue un amincissement du deuxième substrat 134 par sa face arrière, de façon à réaliser des ouvertures 136, 137 dévoilant respectivement les cavités 6, 7 (figure 13D).

On réalise ensuite un remplissage des cavités et des canaux par dispense d'un liquide L approprié à travers les ouvertures 136, 137 (figure 13E). La dispense du liquide L est réalisée par exemple par jet d'encre.

On ferme ensuite à nouveau les cavités 6, 7 en formant les membranes 4, 5. Pour réaliser cela, on peut effectuer un laminage d'un film 138, qui peut être souple et par exemple à base d'une résine photosensible ou de Polyéthylène Téréphtalate (PET), ou de silicone. Ce film 138 est adapté pour adhérer sur le deuxième substrat 134 et peut être gravé afin de former plusieurs membranes distinctes. On peut également prévoir de réaliser une dépôt préalable de colle, par exemple une colle polymérisable aux UV sur le deuxième substrat 134 afin de permettre l'adhésion du film 138 souple. L'adhésion du film 138 sur le substrat 134 est dans ce cas obtenue par polymérisation de la colle après le report du film 138 sur le substrat 134. Le film 138 peut avoir une épaisseur comprise entre plusieurs microns et plusieurs centaines de microns.

On réalise ensuite par dépôt, photolithographie et gravure, les motifs d'électrodes mobiles. Le dépôt métallique peut être précédé tout d'abord d'une couche d'accroche au matériau métallique. La couche d'accroche peut être par exemple à base de Cr ou de Ti et de l'ordre de plusieurs dizaines de nm. Le matériau métallique d'électrode est par exemple du cuivre, ayant une épaisseur qui peut être comprise entre plusieurs dizaines et plusieurs centaines de nm (figure 13F).

On peut ensuite assembler un composant sur une région 139 du deuxième substrat 134 disposée entre les membranes 4, 5, et dévoilant un élément de connexion 90 formé par collage de portions conductrices 133a et 133b.

En variante du procédé précédemment décrit, lorsqu'on souhaite réaliser un dispositif tel qu'illustré sur la figure 7, avec des électrodes situées sous les membranes, on forme ces électrodes sur le film 138, avant report de celui-ci sur le support.

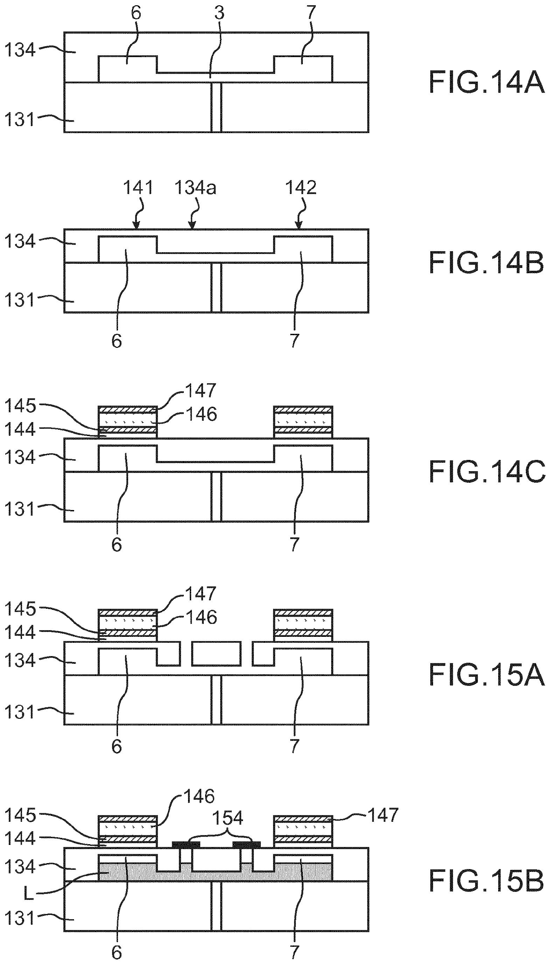

Une autre variante de procédé, pour la mise en oeuvre d'un dispositif à actionnement piézoélectrique, est illustrée sur les figures 14A-14C.

Dans cet exemple, on peut effectuer des étapes d'un procédé tel que décrit précédemment en liaison avec les figures 13A-13C, à l'exception de la formation d'une électrode fixe 69 qui n'est ici pas obligatoire. On assemble ainsi deux substrats 131, 134 pour former un support dans lequel un canal 3 fluidique et des cavités 6, 7 sont prévues (figure 14A).

Ensuite (figure 14B), on réalise un amincissement du deuxième substrat 134 par sa face arrière 134a de manière à conserver une épaisseur par exemple de l'ordre de plusieurs microns. Les membranes sont formées à partir des zones amincies 141, 142 du deuxième substrat 134 et disposées en regard des cavités 6, 7.

Des zones à base de matériau isolant 144 sont ensuite formées sur les zones amincies 141, 142. Un dépôt et une mise en forme par photolithographie et gravure d'un matériau isolant électrique 144, tel que par exemple du SiO₂, d'épaisseur par exemple de plusieurs centaines de nm à plusieurs micromètres peuvent être pour cela réalisés.

On forme ensuite des électrodes inférieures sur les zones de matériau isolant 144. Pour cela, des étapes de dépôt puis de structuration d'une couche à base d'un matériau métallique 145 par exemple tels que du platine ou du ruthénium et d'épaisseur par exemple de l'ordre de plusieurs centaines de nanomètres peuvent être mises en oeuvre.

Puis, on forme des zones de matériau piézoélectrique 146 sur les électrodes inférieures. Pour cela, des étapes de dépôt et de structuration d'une couche de matériau piézoélectrique 146 peuvent être réalisées. Le matériau piézoélectrique 146 peut être par exemple à base de PZT et d'épaisseur comprise entre plusieurs micromètres et plusieurs dizaines de micromètres.

On forme ensuite des électrodes supérieures sur les zones de matériau piézoélectrique 146 (figure 14C). Pour cela, des étapes de dépôt et de structuration d'une couche à base d'un matériau métallique 147 par exemple tel que de l'or et d'épaisseur par exemple de l'ordre de plusieurs centaines de nanomètres peuvent être effectuées.

Un premier exemple de méthode de remplissage du réseau fluidique est illustrée sur les figures 15A-15B.

Le remplissage peut être ensuite réalisé par le biais d'une dispense à travers un ou plusieurs trous ou évents 151, 152 pratiqués dans le support et avantageusement placés en périphérie des membranes 4, 5, les évents 151, 152 débouchant sur le canal fluidique 3 (figure 15A).

Dans ce cas, après avoir rempli le réseau fluidique par un liquide L, une fermeture des évents 151, 152 est effectuée. Cela peut être réalisé par exemple par laminage d'une couche de matériau souple 154 par exemple à base de PET, ou de silicone (figure 15B).

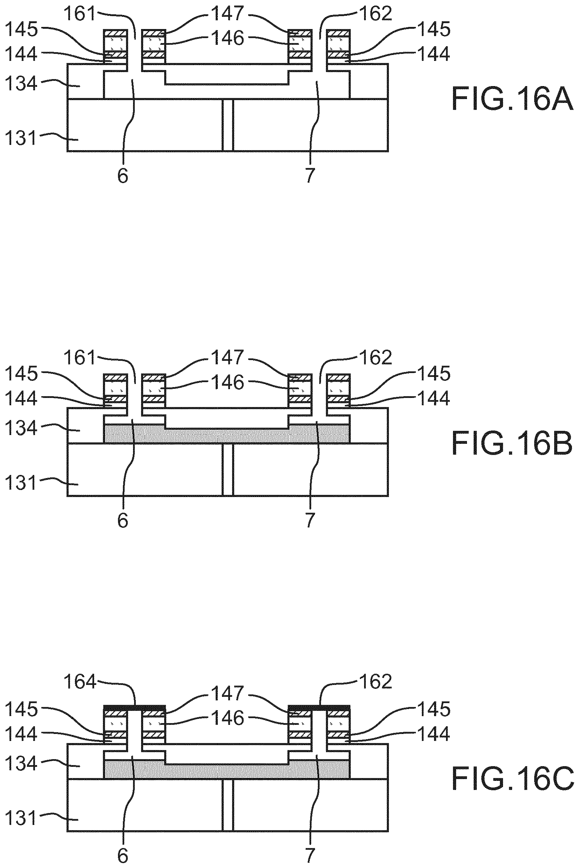

En variante de la méthode précédemment décrite, on peut réaliser des trous ou évents 161, 162 dans les membranes, par exemple par perçage (figure 16A). Ce perçage peut être effectué après avoir formé les électrodes inférieures, la couche de matériau piézoélectrique 146 et les électrodes supérieures. On choisira dans ce cas un dessin adapté pour les électrodes, comme par exemple ajouré dans une partie commune aux électrodes inférieures et aux électrodes supérieures. On remplit ensuite le circuit fluidique par un liquide L dispensé en passant par les évents 161, 162 (figure 16B).

Puis, on ferme les évents 161, 162 par le biais d'un film 164. Le film 164 peut être formé par laminage et à base de polymère (figure 16C).

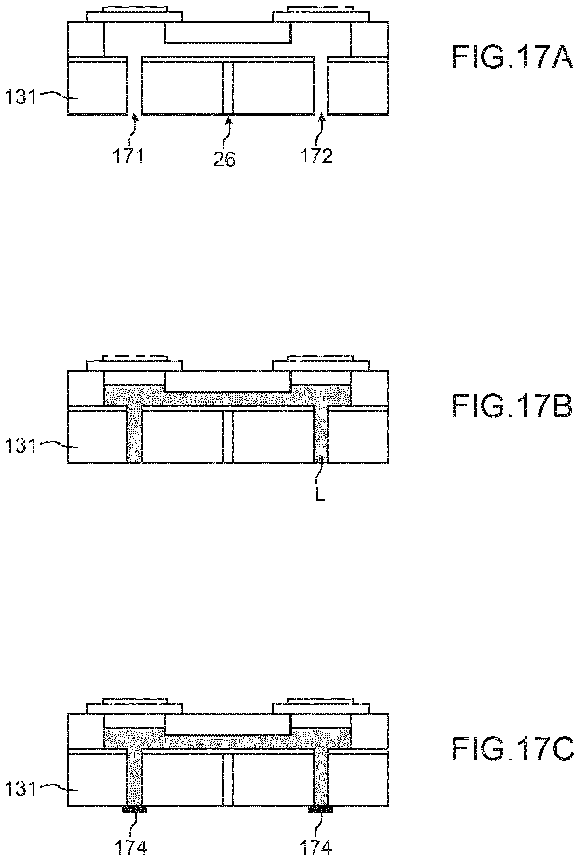

En troisième variante des deux méthodes de fabrication précédentes, on réalise des évents 171,172 par la face arrière du substrat 131 (figure 17A). On peut profiter de l'étape de réalisation du conducteur thermique 26 traversant l'épaisseur du substrat et qui a été décrit précédemment pour creuser les évents 171, 172. Ainsi, on peut réaliser les évents 171,172 lors d'une même étape de gravure que celle permettant de réaliser un trou dans lequel le conducteur thermique 26 est logé.

Puis, après avoir rempli le réseau fluidique par un liquide L à travers les évents 171, 172 (figure 17B), une fermeture des évents 171, 172 est effectuée par exemple par laminage d'une couche de matériau souple 174 (figure 17C) comme décrit dans les deux variantes précédentes.

## Revendications

1. Dispositif pour refroidir au moins un composant comprenant :
- un support (1) destiné à accueillir sur une première face (1a) au moins un composant (2) à refroidir, le support comportant un réseau fluidique (3, 3', 3") dans lequel un liquide est destiné à circuler, le réseau comprenant une première cavité (6), une deuxième cavité (7), et au moins un premier canal (3) reliant la première cavité à la deuxième cavité, une première membrane (4) et une deuxième membrane (5) déformables formant respectivement une paroi mobile de la première cavité et une paroi mobile de la deuxième cavité, le dispositif comprenant en outre :
- des moyens d'actionnement (67, 68, 69) de la première membrane et de la deuxième membrane configurés pour permettre une déformation de la première et/ou de la deuxième membrane de sorte à moduler le volume de la première cavité et/ou la deuxième cavité et à permettre un déplacement du liquide dans le canal,
les moyens d'actionnement comprenant :
- au moins une première électrode (67, 167) disposée sur la première membrane,
- au moins une deuxième électrode (68, 168) disposée sur la deuxième membrane,
**caractérisé en ce que** les moyens d'actionnement comprennent au moins une électrode fixe (69) et disposée sur le support en regard de la première électrode (67) dans la première cavité et/ou de la deuxième électrode (68) dans la deuxième cavité, l'électrode fixe étant disposée sur une ou plusieurs protubérances (102, 112, 114) du support en regard de la première électrode et/ou de la deuxième électrode.

2. Dispositif selon la revendication 1, dans lequel les moyens d'actionnement sont configurés pour alternativement:
- déplacer la première membrane (4) de manière à réduire le volume de la première cavité (6), puis
- déplacer la deuxième membrane (5) de la deuxième cavité de sorte à diminuer le volume de la deuxième cavité.

3. Dispositif selon la revendication 2, dans lequel les moyens d'actionnement sont configurés pour :
- conjointement au déplacement de la première membrane (4) de manière à réduire le volume de la première cavité (6), déplacer la deuxième membrane (5) de sorte à augmenter le volume de la deuxième cavité (7), puis
- conjointement au déplacement de la deuxième membrane de manière à réduire le volume de la deuxième cavité, déplacer la première membrane de la première cavité de sorte à augmenter le volume de la première cavité.

4. Dispositif selon l'une des revendications 1 à 3, dans lequel la première membrane (4) et/ou la deuxième membrane (5) comprennent une couche de matériau piézoélectrique (125).

5. Dispositif selon l'une des revendications 1 à 4, dans lequel les moyens d'actionnement comprennent des moyens de polarisation (65) de la première électrode et de la deuxième électrode, les moyens de polarisation étant avantageusement intégrés au support.

6. Dispositif selon l'une des revendications 1 à 5, dans lequel les moyens d'actionnement comprennent des moyens de polarisation (65) aptes à appliquer un premier potentiel à la première électrode et un deuxième potentiel à la deuxième électrode, différent du premier potentiel.

7. Dispositif selon l'une des revendications 1 à 6, comprenant en outre un élément conducteur thermique (26) à proximité du canal (3) ou en contact avec le canal (3), l'élément conducteur thermique (26) traversant le support depuis le canal ou la proximité du canal vers une deuxième face du support opposée à ladite première face, l'élément conducteur thermique ayant une conductivité thermique plus élevée que la conductivité thermique du support.

8. Dispositif selon la revendication 7, dans lequel l'élément conducteurthermique (26) est relié à une zone conductrice thermique (86) située sur ladite deuxième face (1b) du support.

9. Dispositif selon l'une des revendications 1 à 8, comprenant en outre un élément de connexion électrique (90) traversant le support et reliant la première face (1a) du support sur laquelle le composant est destiné à être disposé et la deuxième face (1b) opposée à la première face.

10. Dispositif selon l'une des revendication 1 à 9, comprenant m cavités, avec m supérieur ou égal à 2, et au moins n canaux avec n supérieur ou égal à 1 permettant de former un réseau fluidique reliant l'ensemble des cavités entre elles.

11. Dispositif selon l'une des revendications 1 à 9, comprenant en outre un moyen de mesure de la température du composant et un moyen de commande des moyens d'actionnement en fonction de la température mesurée par le moyen de mesure.

12. Dispositif selon l'une des revendications 1 à 11, comportant au moins une rainure (201, 202) entre deux protubérances (102, 112, 114), la rainure (201, 202) s'étendant dans une direction parallèle à celle du premier canal (3).

13. Procédé de réalisation d'un dispositif selon l'une des revendications 1 à 12, comprenant des étapes consistant à :
- assembler un premier substrat (131) avec un deuxième substrat (134) ledit au moins un canal fluidique (3) et des ouvertures destinées à former la première et ou la deuxième cavité étant au moins partiellement réalisés dans le premier et/ou le deuxième substrat,
- former les membranes (4,5) à partir d'une ou plusieurs zones amincies (141, 142) du deuxième substrat (134) et/ou par report d'au moins une couche (138) sur le deuxième substrat (134) de manière à fermer les ouvertures (136, 137).

14. Procédé selon la revendication 13, comprenant avant la fermeture des ouvertures par les membranes, une étape de remplissage dudit au moins un canal et des cavités par un liquide (L).

15. Procédé selon la revendication 14, comprenant après la fermeture des ouvertures par les membranes une étape de remplissage dudit au moins canal et des cavités, cette étape consistant à :
- pratiquer au moins un évent (151, 152, 161, 162) dans le deuxième substrat (134) ou le premier substrat de sorte que ledit évent débouche dans ledit au moins canal,
- remplir ledit au moins canal et les cavités par un liquide (L) dispensé à travers ledit évent (151, 152, 161, 162),
- déposer un film (154, 164) de fermeture dudit au moins évent.

16. Procédé selon la revendication 15, dans lequel ledit au moins évent (161, 162) traversent des zones amincies du deuxième substrat (134).

17. Procédé selon l'une des revendications 13 à 16, dans lequel le premier substrat (131) est doté d'une portion électriquement conductrice (133a) traversant son épaisseur et dans lequel le deuxième substrat (134) comporte une autre portion électriquement conductrice (133b) en contact avec une région (139) sur laquelle le composant est destiné à être disposé, l'assemblage entre le premier substrat et le deuxième substrat étant réalisé de sorte à mettre en contact électrique entre elles la portion conductrice (133a) et l'autre portion conductrice (133b).

18. Procédé selon l'une des revendications 13 à 17, dans lequel l'assemblage entre le premier substrat (131) et le deuxième substrat (134) est réalisé par collage direct métal/métal.

## Patentansprüche

1. Verfahren, um wenigstens ein Bauteil abzukühlen, umfassend:
- einen Träger (1), der dazu bestimmt ist, auf einer ersten Seite (1a) wenigstens ein abzukühlendes Bauteil (2) aufzunehmen, wobei der Träger ein Fluid-Netzwerk (3, 3', 3") umfasst, in welchem eine Flüssigkeit zirkulieren soll, wobei das Netzwerk eine erste Ausnehmung (6), eine zweite Ausnehmung (7) und wenigstens einen ersten Kanal (3) umfasst, der die erste Ausnehmung mit der zweiten Ausnehmung verbindet, wobei eine erste Membran (4) und eine zweite Membran (5), die verformbar sind, eine bewegliche Wand der ersten Ausnehmung bzw. eine bewegliche Wand der zweiten Ausnehmung bilden, wobei die Vorrichtung weiterhin umfasst:
- Betätigungsmittel (67, 68, 69) der ersten Membran und der zweiten Membran, die dazu konfiguriert sind, eine Verformung der ersten oder/und der zweiten Membran zu erlauben, so dass das Volumen der ersten Ausnehmung oder/und der zweiten Ausnehmung moduliert wird, und um eine Verlagerung der Flüssigkeit im Kanal zu erlauben,
wobei die Betätigungsmittel umfassen:
- wenigstens eine erste Elektrode (67, 167), die auf der ersten Membran angeordnet ist,
- wenigstens eine zweite Elektrode (68, 168), die auf der zweiten Membran angeordnet ist,
**dadurch gekennzeichnet, dass** die Betätigungsmittel wenigstens eine feste und auf dem Träger gegenüber der ersten Elektrode (67) in der ersten Ausnehmung oder/und der zweiten Elektrode (68) in der zweiten Ausnehmung angeordnete Elektrode (69) umfassen, wobei die feste Elektrode auf einem oder mehreren Vorsprüngen (102, 112, 114) des Trägers gegenüber von der ersten Elektrode oder/und der zweiten Elektrode angeordnet ist.

2. Vorrichtung nach Anspruch 1, wobei die Betätigungsmittel dazu konfiguriert sind, abwechselnd
- die erste Membran (4) so zu verlagern, dass das Volumen der ersten Ausnehmung (6) reduziert wird, und dann
- die zweite Membran (5) der zweiten Ausnehmung so zu verlagern, dass das Volumen der zweiten Ausnehmung verkleinert wird.

3. Vorrichtung nach Anspruch 2, wobei die Betätigungsmittel dazu konfiguriert sind:
- zusammen mit der Verlagerung der ersten Membran (4), so dass das Volumen der ersten Ausnehmung (6) reduziert wird, die zweite Membran (5) so zu verlagern, dass das Volumen der zweiten Ausnehmung (7) vergrößert wird, und dann
- zusammen mit der Verlagerung der zweiten Membran, so dass das Volumen der zweiten Ausnehmung reduziert wird, die erste Membran der ersten Ausnehmung so zu verlagern, dass das Volumen der ersten Ausnehmung vergrößert wird.

4. Vorrichtung nach einem der Ansprüche 1 bis 3, wobei die erste Membran (4) oder/und die zweite Membran (5) eine Schicht aus einem piezoelektrischen Material (125) umfassen.

5. Vorrichtung nach einem der Ansprüche 1 bis 4, wobei die Betätigungsmittel Mittel zur Polarisation (65) der ersten Elektrode und der zweiten Elektrode umfassen, wobei die Mittel zur Polarisation bevorzugt an dem Träger integriert sind.

6. Vorrichtung nach einem der Ansprüche 1 bis 5 wobei die Betätigungsmittel Mittel zur Polarisation (65) umfassen, die dazu geeignet sind, ein erstes Potenzial an die erste Elektrode anzulegen und ein zweites Potenzial, welches sich vom ersten Potenzial unterscheidet, an die zweite Elektrode anzulegen.

7. Vorrichtung nach einem der Ansprüche 1 bis 6, weiterhin umfassend ein Wärmeleiterelement (26) in der Umgebung des Kanals (3) oder in Kontakt mit dem Kanal (3), wobei das Wärmeleiterelement (26) den Träger von dem Kanal oder von der Umgebung des Kanals aus zu einer zweiten Seite des Trägers hin durchquert, die der ersten Seite gegenüberliegt, wobei das Wärmeleiterelement eine Wärmeleitfähigkeit aufweist, die höher ist als die Wärmeleitfähigkeit des Trägers.

8. Vorrichtung nach Anspruch 7, wobei das Wärmeleiterelement (26) mit einem wärmeleitenden Bereich (86) verbunden ist, der auf der zweiten Seite (1 b) des Trägers liegt.

9. Vorrichtung nach einem der Ansprüche 1 bis 8, weiterhin umfassend ein Element (90) zur elektrischen Verbindung, welches den Träger durchquert und die erste Seite (1a) des Trägers, auf welcher das Bauteil angeordnet werden soll, und die der ersten Seite gegenüberliegende zweite Seite (1 b) verbindet.

10. Vorrichtung nach einem der Ansprüche 1 bis 9, umfassend m Ausnehmungen, wobei m größer oder gleich 2 ist, und wenigstens n Kanäle, wobei n größer oder gleich 1 ist, die es ermöglichen, ein Fluid-Netzwerk zu bilden, welches die Anordnung der Ausnehmungen untereinander verbindet.

11. Vorrichtung nach einem der Ansprüche 1 bis 9, weiterhin umfassend ein Messmittel für die Temperatur des Bauteils und ein Mittel zur Steuerung/Regelung der Betätigungsmittel in Abhängigkeit der durch das Messmittel gemessenen Temperatur.

12. Vorrichtung nach einem der Ansprüche 1 bis11, umfassend wenigstens eine Rille (201, 202) zwischen zwei Vorsprüngen (102, 112, 114), wobei die Rille (201, 202) sich in eine Richtung parallel zu derjenigen des ersten Kanals (3) erstreckt.

13. Verfahren zur Herstellung einer Vorrichtung nach einem der Ansprüche 1 bis 12, umfassend Schritte, die darin bestehen:
- ein erstes Substrat (131) mit einem zweiten Substrat (134) zusammenzufügen, wobei der wenigstens eine Fluid-Kanal (3) und Öffnungen, die dazu bestimmt sind, die erste oder/und die zweite Ausnehmung zu bilden, wenigstens teilweise in dem ersten oder/und dem zweiten Substrat ausgeführt sind,
- Membranen (4, 5) ausgehend von einem oder mehreren verdünnten Bereichen (141, 142) des zweiten Substrats (134) zu bilden, oder/und durch Übertragen von wenigstens einer Schicht (138) auf das zweite Substrat (134), so dass die Öffnungen (136, 137) geschlossen werden.

14. Verfahren nach Anspruch 13, umfassend, vor dem Verschließen der Öffnungen durch die Membranen, einen Schritt des Auffüllens des wenigstens einen Kanals und der Ausnehmungen durch eine Flüssigkeit (L).

15. Verfahren nach Anspruch 14, umfassend, nach dem Verschließen der Öffnungen durch die Membranen, einen Schritt des Auffüllens des wenigstens einen Kanals und der Ausnehmungen, wobei dieser Schritt darin besteht,
- wenigstens eine Durchlassöffnung (151, 152, 161, 162) in das zweite Substrat (134) oder das erste Substrat einzubringen, so dass die Durchlassöffnung in den wenigstens einen Kanal mündet,
- den wenigstens einen Kanal und die Ausnehmungen mit einer Flüssigkeit (L) zu füllen, die über die Durchlassöffnung (151, 152, 161, 162) ausgegeben wird,
- eine Folie (154, 164) zum Verschließen der wenigstens einen Durchlassöffnung aufzubringen.

16. Verfahren nach Anspruch 15, wobei die wenigstens eine Durchlassöffnung (161, 162) die verdünnten Bereiche des zweiten Substrats (134) durchquert.

17. Verfahren nach einem der Ansprüche 13 bis 16, wobei das erste Substrat (131) mit einem elektrisch leitenden Abschnitt (133a) ausgestattet ist, der dessen Dicke durchquert, und wobei das zweite Substrat (134) einen anderen elektrisch leitenden Abschnitt (133b) umfasst, in Kontakt mit einem Bereich (139), auf welchem das Bauteil angeordnet werden soll, wobei das Zusammenfügen von dem ersten Substrat und dem zweiten Substrat so ausgeführt wird, dass der leitende Abschnitt (133a) und der andere leitende Abschnitt (133b) miteinander in elektrischen Kontakt gebracht werden.

18. Verfahren nach einem der Ansprüche 13 bis 17, wobei das Zusammenfügen von dem ersten Substrat (131) und dem zweiten Substrat (134) durch direktes Metall-auf-Metall Verkleben/Verschweißen ausgeführt wird.

## Claims

1. Device for cooling at least one component comprising:
- a support (1) that will receive on a first face (1a) at least one component (2) to be cooled, the support comprising a fluid network (3, 3', 3") inside which a liquid will circulate, the network comprising a first cavity(6), a second cavity (7), and at least one first channel (3) connecting the first cavity to the second cavity, a first deformable membrane (4) and a second (5) deformable membrane forming a mobile wall of the first cavity and a mobile wall of the second cavity respectively, the device further comprising :
- actuating means (67, 68, 69) of the first membrane and the second membrane, configured to enable deformation of the first and/or the second membrane so as to vary the volume of the first cavity and/or the second cavity and to enable displacement of the liquid in the channel,
**characterized in that** the actuating means comprise:
- at least one first electrode (67, 167) located on the first membrane,
- at least one second electrode (68, 168) located on the second membrane,
**characterised in that** the actuating means comprise:
- at least one fixed electrode (69) located on the support and facing the first electrode (67) in the first cavity and/or the second electrode (68) in the second cavity, the fixed electrode being located on one or several protuberances (102, 112, 114) of the support said protuberances facing the first electrode and/or the second electrode.

2. The device according to claim 1, wherein the actuating device is configured to alternately:
- displace the first membrane (4) so as to reduce the volume of the first cavity (6), then
- displace the second membrane (5) so as to reduce the volume of the second cavity.

3. The device according to claim 2, wherein the actuating means are configured to:
- jointly with displacement of the first membrane (4) so as to reduce the volume of the first cavity (6), displace the second membrane (5) so as to increase the volume of the second cavity (7), then
- jointly with displacement of the second membrane so as to reduce the volume of the second cavity, displace the first membrane of the first cavity so as to increase the volume of the first cavity.

4. The device according to any of claims 1 to 3, wherein the first membrane (4) and/or the second membrane (5) comprise a layer of piezoelectric material (125).

5. The device according to any of claims 1 to 4, wherein the actuating means comprise biasing means (65) for biasing the first electrode and the second electrode, the biasing means being advantageously integrated into the support.

6. The device according to any of claims 1 to 5, wherein the actuating means comprise biasing means (65) capable of applying a first potential to the first electrode and a second potential to the second electrode, different from the first potential.

7. The device according to any of claims 1 to 6, further comprising a thermal conducting element (26) close to the channel (3) or in contact with the channel (3), the thermal conducting element (26) passing through the support from the channel or close to the channel towards a second face of the support opposite said first face, the thermal conducting element having a thermal conductivity higher than the thermal conductivity of the support.

8. The device according to claim 7, wherein the thermal conducting element (26) is connected to a heat conducting zone (86) located on said second face (1b) of the support.

9. The device according to any of claims 1 to 8, further comprising an electrical connection element (90) passing through the support and connecting the first face (1a) of the support on which the component is to be located and the second face (1b) opposite the first face.

10. The device according to any of claims 1 to 9, comprising m cavities where m is greater than or equal to 2 and at least n channels where n is greater than or equal to 1 making it possible to form a fluid network connecting all cavities together.

11. The device according to any of claims 1 to 9, further comprising means for measuring the temperature of the component and a control means for controlling the actuating means as a function of the temperature measured by the measurement means.

12. The device according to any of claims 1 to 11, comprising at least one groove (201, 202) between two protuberances (102, 112, 114), the groove (201, 202) extending in a direction parallel to the first channel (3).

13. A method of manufacturing a device according to one of claims 1 to 12, comprising steps consisting of:
- assembling a first substrate (131) with a second substrate (134), said at least one fluid channel (3) and openings designed to form the first and/or the second cavity being at least partially made in the first and/or second substrate,
- forming membranes (4, 5) from one or several thinned zones (141, 142) of the second substrate (134) and/or by transferring at least one layer (138) on the second substrate (134) so as to close the openings (136,137).

14. The method according to claim 13, comprising a step of filling said at least one channel and cavities by a liquid (L), said filling being conducted before the openings are closed by the membranes.

15. The method according to claim 14, comprising a step of filling said at least one channel and cavities after the openings have been closed by the membranes, this step consisting of:
- forming at least one vent (151, 152, 161, 162) in the second substrate (134) or the first substrate such that said vent opens up in said at least one channel,
- filling said at least one channel and the cavities with a liquid (L) dispensed through said vent (151, 152, 161, 162),
- depositing a film (154, 164) to close off said at least one vent.

16. The method according to claim 15, wherein said at least one vent (161, 162) passes through thinned zones of the second substrate (134).

17. The method according to any of claims 13 to 16, wherein the first substrate (131) is provided with an electrically conducting portion (133a) passing through its thickness and in which the second substrate (134) comprises another electrically conducting portion (133b) in contact with a region (139) on which the component will be located, the assembly between the first substrate and the second substrate being made so as to bring the conducting portion (133a) into electrical contact with the other conducting portion (133b).

18. The method according to any of claims 13 to 17, wherein the assembling between the first substrate (131) and the second substrate (134) is done by direct metal / metal bonding.
